# EUROPEAN PATENT APPLICATION

(11) **EP 4 362 644 A1**
(43) Date of publication of application: **01.05.2024**
(21) Application number: 23205895.8
(22) Date of filing: 25.10.2023
(51) Int. Cl.: H10K 71/20, H10K 59/122

(54) **ORGANIC LIGHT EMITTING ELEMENT**

(30) Priority: 25.10.2022 US 202263380812 P; 12.10.2023 CN 202311322604
(71) Applicant: Taizhou Guanyu Technology Co., Ltd., Taizhou City, Zhejiang Province (CN)
(72) Inventor: CHEN, Huei-Siou, 103 Taipei City (TW); WEI, Li-Chen, 406 Taichung City (TW); HSU, Kuo-Cheng, 406 Taichung City (TW); CHU, Ker Tai, 11494 Taipei City (TW)
(74) Representative: Michalski Hüttermann & Partner Patentanwälte mbB

(57) **Abstract**

An organic light emitting element includes a substrate, a first electrode (215), an organic light emitting layer (20), and a fluorine-containing ion residue region (400). The first electrode is over the substrate (250). The organic light emitting layer is over the first electrode. The fluorine-containing ion residue region is on at least one surface of the organic light emitting layer.

## Description

### BACKGROUND OF THE PRESENT DISCLOSURE

### FIELD OF THE PRESENT DISCLOSURE

The present disclosure relates to an organic light emitting element, and more particularly to an organic light emitting element including an organic light emitting diode (OLED) structure.

### DESCRIPTION OF THE PRIOR ART

Currently, a fine metal mask (FMM) is commonly used in a coating step for a light emitting layer of an organic light emitting element. Alternatively, a white light in combination with a color film are used for the above manufacturing process. However, fineness or resolution of pixels manufactured by the manufacturing processes above is rather poor.

### SUMMARY OF THE PRESENT DISCLOSURE

In the present disclosure, an organic light emitting element includes a substrate, a first electrode, an organic light emitting layer and a fluorine-containing ion residue region. The first electrode is over the substrate. The organic light emitting layer is over the first electrode. The fluorine-containing ion residue region is on at least one surface of the organic light emitting layer.

In some embodiments, the fluorine-containing ion residue region includes -C-F ions, a compound containing the C-F ions, fluoride ions, a compound containing the fluoride ions, a residue of the above, or any combination thereof.

In some embodiments, the fluorine-containing ion residue region is further located between the organic light emitting layer and the first electrode.

In some embodiments, the organic light emitting element further includes a protrusion structure, which is located over the substrate and partially covers the first electrode, wherein the fluorine-containing ion residue region is further located over the protrusion structure.

In some embodiments, the fluorine-containing ion residue region is further located between the organic light emitting layer and the protrusion structure.

In some embodiments, the organic light emitting element further includes a second electrode which is located over the organic light emitting layer, wherein the fluorine-containing ion residue region is further located between the organic light emitting layer and the second electrode.

In some embodiments, the second electrode is further located over the protrusion structure, and the fluorine-containing ion residue region is further located between the protrusion structure and the second electrode.

In some embodiments, a fluorine-containing ion concentration of the fluorine-containing ion residue region over the protrusion structure is higher than a fluorine-containing ion concentration of the fluorine-containing ion residue region over the organic light emitting layer.

In some embodiments, the organic light emitting layer further includes a plurality of material layers, and the fluorine-containing ion residue region is further located among the plurality of material layers.

In some embodiments, at least one of the substrate, the first electrode, and the organic light emitting layer is substantially free of fluorine.

### BRIEF DESCRIPTION OF THE DRAWINGS

FIG. 1 is a top view of an exemplary intermediate product of an organic light emitting element according to some embodiments;
FIG. 2 is a cross-section along the line A-A' in FIG. 1 according to some embodiments;
FIG. 3 is a cross-section along the line B-B' in FIG. 1 according to some embodiments; and
FIG. 4A to FIG. 4I illustrate a method for manufacturing an organic light emitting element according to some embodiments.

### DETAILED DESCRIPTION OF THE EMBODIMENTS

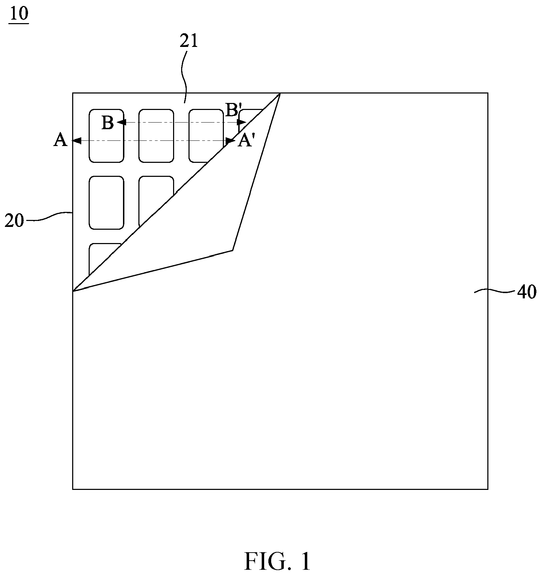

FIG. 1 shows a top view of an exemplary intermediate product of an organic light emitting element 10. The organic light emitting element 10 includes an organic light emitting layer 20 and a cover layer 40 located over the organic light emitting layer 20. For the organic light emitting layer 20, a spacer may be designed to provide an array of recesses used to accommodate a light emitting pixel array. In some embodiments, the spacer may include a protrusion structure 21. In some embodiments, the spacer may include a photosensitive material.

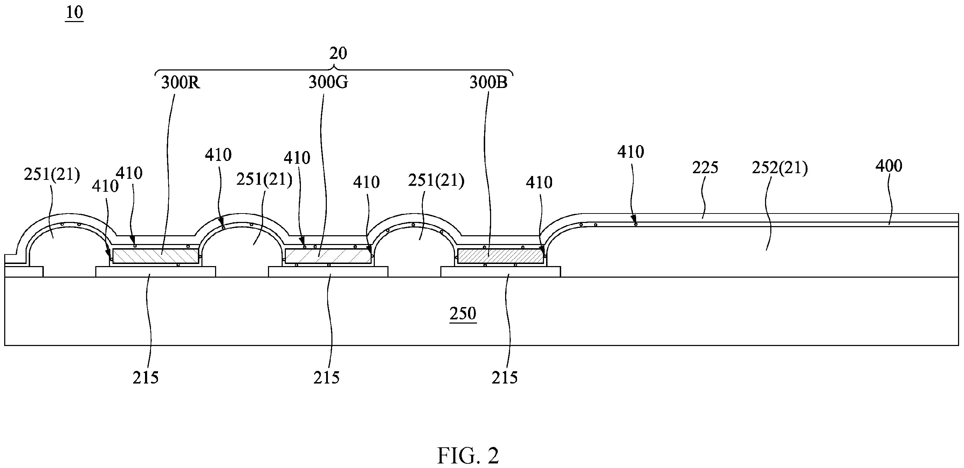

In some embodiments, FIG. 2 shows a cross-section along the line A-A' in FIG. 1, and only a light emitting region is illustrated. For brevity and clarity, the cover layer 40 is omitted. The protrusion structure 21 includes a plurality of protrusions 251 and 252 to define a light emitting pixel pattern. The recess is located between two adjacent protrusions and provides a space for accommodating light emitting pixels. A person skilled in the art would be able to understand that the protrusions 251 and the protrusions 252 are illustrated in a disconnected manner as viewed in a cross-sectional view perspective. However, the protrusions may be connected to one another by other parts of the protrusion structure 21 as viewed in a top view perspective, as illustrated in FIG. 1.

As shown in FIG. 2, in some embodiments, the organic light emitting element 10 is, for example, a light emitting element including an organic light emitting diode (OLED).

In some embodiments, the organic light emitting element 10 includes a substrate 250, an electrode 215 (or referred to as a first electrode), an electrode 225 (or referred to as a second electrode), an organic light emitting layer 20, the protrusion structure 21, and a fluorine-containing ion residue region 400.

In some embodiments, the substrate 250 includes glass. In some embodiments, the substrate 250 is substantially free of fluorine. In some embodiments, the substrate 250 may include a transistor array, which is configured to correspond to the light emitting pixels in the organic light emitting layer 20. The substrate 250 may include a plurality of capacitors. In some embodiments, more than one transistor may be configured with one capacitor and one light emitting pixel to form a circuit.

In some embodiments, the electrode 215 is over the substrate 250. In some embodiments, the electrode 215 is an anode. In some embodiments, the electrode 215 includes a metal material, for example, Ag, Al, Mg, Au, AlCu alloy, or AgMo alloy. In some embodiments, the electrode 215 includes indium tin oxide (ITO), indium zinc oxide (IZO), or other suitable materials. In some embodiments, the electrode 215 is substantially free of fluorine.

In some embodiments, the organic light emitting layer 20 is over the electrode 215. In some embodiments, the organic light emitting layer 20 substantially does not contain fluorine. In some embodiments, the organic light emitting layer 20 may include multiple light emitting layers 300R, 300B and 300G. In some embodiments, each of the light emitting layers 300R, 300B and 300G may include multiple material layers, for example, a hole transportation layer (HTL), an emissive layer (EML), an electron transportation layer (ETL), a hole blocking layer (HBL), a hole injection layer (HIL), a hole transportation layer (HTL), or any combination thereof. In some embodiments, the light emitting layers 300R, 300B and 300G emit lights have the same color or different colors. In some embodiments, the light emitting layer 300R emits red light, the light emitting layer 300G emits green light, and the light emitting layer 300B emits blue light. In some embodiments, the organic light emitting layer 300R, 300B and 300G are substantially free of fluorine.

In some embodiments, the organic light emitting layer 20 includes an organic material, which may be disposed in any of the light emitting layers 300R, 300B and 300G by various techniques. In some embodiments, the organic material has an absorption rate of greater than or equal to 50% for a light having a specific wavelength. In some embodiments, the organic material has an absorption rate of greater than or equal to 60% for a light having a specific wavelength. In some embodiments, the organic material has an absorption rate of greater than or equal to 70% for a light having a specific wavelength. In some embodiments, the organic material has an absorption rate of greater than or equal to 80% for a light having a specific wavelength. In some embodiments, the organic material has an absorption rate of greater than or equal to 90% for a light having a specific wavelength. In some embodiments, the organic material has an absorption rate of greater than or equal to 95% for a light having a specific wavelength. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

In some embodiments, the protrusion structure 21 is over the substrate 250 and partially covers the electrode 215. In some embodiments, the protrusion structure 21 may include the protrusions 251 and the protrusions 252. In some embodiments, the protrusion structure 21 has a pattern designed according to a pixel layout. In some embodiments, the protrusion structure 21 serves as a pixel defined layer (PDL). In some embodiments, the protrusions 251 define a pixel region, and the protrusions 252 are located in a peripheral region. In some embodiments, each protrusion 251 is filled in a gap between two adjacent electrodes 215. Each electrode 215 is partially covered by the protrusions 251. In some embodiments, the protrusion structure 21 includes an organic insulating material. In some embodiments, the protrusion structure 21 includes a photosensitive material. In some embodiments, the protrusion structure 21 is substantially free of fluorine.

In some embodiments, the protrusion structure 21 has an absorption rate of greater than or equal to 50% for a light having a specific wavelength. In some embodiments, the protrusion structure 21 has an absorption rate of greater than or equal to 60% for a light having a specific wavelength. In some embodiments, the protrusion structure 21 has an absorption rate of greater than or equal to 70% for a light having a specific wavelength. In some embodiments, the protrusion structure 21 has an absorption rate of greater than or equal to 80% for a light having a specific wavelength. In some embodiments, the protrusion structure 21 has an absorption rate of greater than or equal to 90% for a light having a specific wavelength. In some embodiments, the protrusion structure 21 has an absorption rate of greater than or equal to 95% for a light having a specific wavelength. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

In some embodiments, the electrode 225 is over the organic light emitting layer 20. In some embodiments, the electrode 225 is over the organic light emitting layer 300R, 300B and 300G. In some embodiments, the electrode 225 is a cathode. In some embodiments, the electrode 225 may be further located over the protrusion structure 21. In some embodiments, the electrode 225 is a common electrode of all light emitting pixels in the organic light emitting layer 20. In some embodiments, the electrode 225 includes a metal material, for example, Ag, Al, Mg, Au, AlCu alloy, or AgMo alloy. In some embodiments, the electrode 225 includes ITO, IZO, or other suitable materials. In some embodiments, the electrode 225 is substantially free of fluorine.

In some embodiments, the fluorine-containing ion residue region 400 is located on at least one surface of the organic light emitting layer 20. In some embodiments, the fluorine-containing ion residue region 400 may be located on at least one surface of the electrode 215. In some embodiments, the fluorine-containing ion residue region 400 may be located on at least one surface of the protrusion structure 21. In some embodiments, the fluorine-containing ion residue region 400 may include a fluorine-containing ion material 410, which includes, for example, -C-F ions, a compounding containing C-F ions, fluoride ions, a compound containing fluoride ions, a residue thereof, or any combination thereof.

In some embodiments, the fluorine-containing ion residue region 400 or the fluorine-containing ion material 410 may be located between the electrode 215 and the organic light emitting layer 20 (for example, the light emitting layers 300R, 300B and 300G). In some embodiments, the fluorine-containing ion residue region 400 or the fluorine-containing ion material 410 may be located at an interface between the electrode 215 and the organic light emitting layer 20 (for example, the light emitting layers 300R, 300B and 300G). In some embodiments, the fluorine-containing ion residue region 400 or the fluorine-containing ion material 410 may be located between the protrusion structure 21 and the organic light emitting layer 20 (for example, the light emitting layers 300R, 300B and 300G). In some embodiments, the fluorine-containing ion residue region 400 or the fluorine-containing ion material 410 may be located at an interface between the protrusion structure 21 and the organic light emitting layer 20 (for example, the light emitting layers 300R, 300B and 300G). In some embodiments, the Fluorine-containing ion residue region 400 or the fluorine-containing ion material 410 may be located on a sidewall surface of the organic light emitting layer 20 (for example, the light emitting layers 300R, 300B and 300G). In some embodiments, the fluorine-containing ion residue region 400 or the fluorine-containing ion material 410 may be located between the organic light emitting layer 20 (for example, the light emitting layers 300R, 300B and 300G) and the electrode 225 (cathode) located above. In some embodiments, the fluorine-containing ion residue region 400 or the fluorine-containing ion material 410 may be located at an interface between the organic light emitting layer 20 (for example, the light emitting layers 300R, 300B and 300G) and the electrode 225 (cathode) located above. In some embodiments, the fluorine-containing ion residue region 400 or the fluorine-containing ion material 410 may be further located between the protrusion structure 21 and the electrode 225. In some embodiments, the fluorine-containing ion residue region 400 or the fluorine-containing ion material 410 may be further located at an interface between the protrusion structure 21 and the electrode 225.

In some embodiments, the fluorine-containing ion residue region 400 or the fluorine-containing ion material 410 may be not located at an interface between the electrode 215 and the protrusion structure 21. In some embodiments, the fluorine-containing ion residue region 400 or the fluorine-containing ion material 410 may be not located at an interface between the electrode 215 and the substrate 250.

In some embodiments, the fluorine-containing ion residue region 400 or the fluorine-containing ion material 410 may be further located at an interface among the plurality of material layers. In some embodiments, the fluorine-containing ion residue region 400 or the fluorine-containing ion material 410 may be further located among the plurality of material layers. In some embodiments, the fluorine-containing ion residue region 400 or the fluorine-containing ion material 410 may be located between any two layers of the HTL, EML, ETL, HBL, HIL, and HTL of the organic light emitting layers 300R, 300B and 300G. In some embodiments, the fluorine-containing ion residue region 400 or the fluorine-containing ion material 410 may be located at an interface between any two layers of the HTL, EML, ETL, HBL, HIL and HTL of the organic light emitting layers 300R, 300B and 300G.

In some embodiments, the fluorine-containing ion residue region 400 or the fluorine-containing ion material 410 may reside in a non-uniform manner over the electrode 215, the organic light emitting layer 20 (for example, the light emitting layers 300R, 300B and 300G), and the protrusion structure 21. For example, a fluorine-containing ion concentration of the fluorine-containing ion residue region 400 over the protrusion structure 21 is, for example, higher than a fluorine-containing ion concentration of the fluorine-containing ion residue region 400 over the organic light emitting layer 20 (for example, the light emitting layers 300R, 300B and 300G). For example, a concentration of a fluorine-containing ion and/or a compound containing fluorine-containing ions over the protrusion 252 may be higher than a concentration of a fluorine-containing ion and/or a compound containing fluorine-containing ions over the protrusion 251. For example, a concentration of a fluorine-containing ion and/or a compound containing fluorine-containing ions over the protrusion structure 21 may be higher than a concentration of a fluorine-containing ion and/or a compound containing fluorine-containing ions over the organic light emitting layer 20 (for example, the light emitting layers 300R, 300B and 300G). For example, a concentration of a fluorine-containing ion and/or a compound containing fluorine-containing ions over the protrusion structure 21 may be higher than a concentration of a fluorine-containing ion and/or a compound containing fluorine-containing ions over the electrode 215.

In some embodiments, the fluorine-containing ion residue region 400 is illustrated as a specific film layer in FIG. 2. However, in some embodiments, the fluorine-containing ion residue region 400 is a region formed from the fluorine-containing ion material 410 located at a surface interface and does not have a specific or substantial thickness, and the fluorine-containing ion residue region 400 shown in FIG. 2 is depicted to merely indicate its location. In some embodiments, IR spectroscopy may be used for the qualitative measurement (IR absorption peak) and quantitative measurement (integrated area of IR absorption peak) of -C-F-ions and the compound containing -C-F-ions of the fluorine-containing ion residue region 400 or the fluorine-containing ion material 410. In some embodiments, ICP-MS may be used for the qualitative and quantitative measurements of fluoride ions and the compound containing fluoride ions of the fluorine-containing ion residue region 400 or the fluorine-containing ion material 410. In some embodiments, the location of the fluorine-containing ion residue region 400 can be measured by means of changing the measurement depth of EDS in combination with a qualitative result of the EDS.

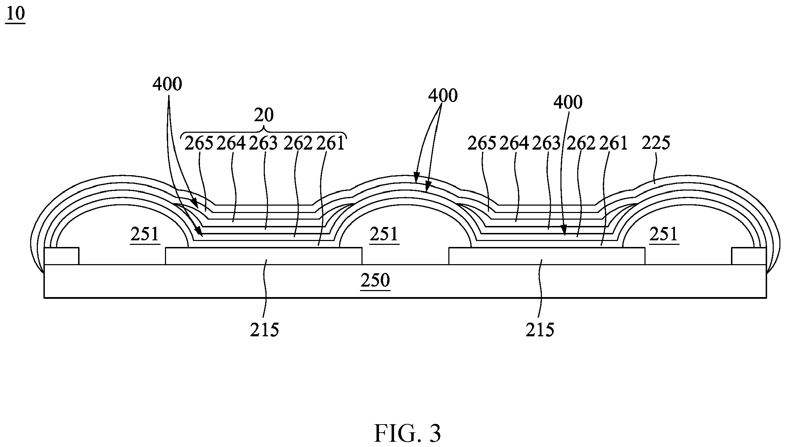

In some embodiments, FIG. 3 shows a cross-section along the line B-B' in FIG. 1, and only a light emitting region is illustrated. For brevity and clarity, the cover layer 40 is omitted.

As shown in FIG. 3, in some embodiments, the organic light emitting element 10 may include a substrate 250, electrodes 215 and 225, protrusions 251 (or a pixel defining layer), and an organic light emitting layer 20. In some embodiments, the organic light emitting layer 20 may include a carrier injection layer 261, carrier transportation layers 262 and 263, an organic emissive layer 264, and an organic carrier transportation layer 265.

In some embodiments, the fluorine-containing ion residue region 400 or the fluorine-containing ion material may be over the organic carrier transport layer 265. In some embodiments, the fluorine-containing ion residue region 400 or the fluorine-containing ion material may be located between the organic carrier transportation layer 265 and the organic emissive layer 264. In some embodiments, the fluorine-containing ion residue region 400 or the fluorine-containing ion material may be located between the carrier transportation layer 263 and the organic emissive layer 264. In some embodiments, the fluorine-containing ion residue region 400 or the fluorine-containing ion material may be located between the carrier transportation layer 263 and the carrier transportation layer 262. In some embodiments, the fluorine-containing ion residue region 400 or the fluorine-containing ion material may be located between the carrier injection layer 261 and the carrier transportation layer 262. In some embodiments, the fluorine-containing ion residue region 400 or the fluorine-containing ion material may be located between the organic carrier transportation layer 265 and the carrier transportation layer 262.

In some embodiments, the fluorine-containing ion residue region 400 or the fluorine-containing ion material may be located between the electrode 215 and the carrier injection layer 261. In some embodiments, the fluorine-containing ion residue region 400 or the fluorine-containing ion material may be located between the protrusions 251 and the carrier injection layer 261. In some embodiments, the fluorine-containing ion residue region 400 or the fluorine-containing ion material may be located between the electrode 225 and the organic carrier transportation layer 265.

In some embodiments, the substrate 250, the electrode 215, the electrode 225, the protrusions 251 (or the pixel defining layer), and the organic light emitting layer 20 are substantially free of fluorine. In some embodiments, the carrier injection layer 261, the carrier transportation layers 262 and 263, the organic emissive layer 264, and the organic carrier transport layer 265 are substantially free of fluorine.

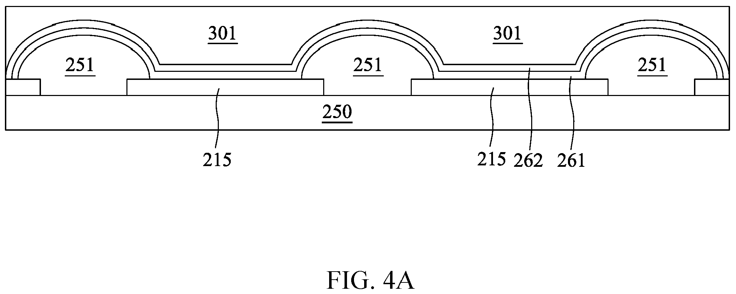

FIG. 4A to FIG. 4I illustrate a method for manufacturing an organic light emitting element according to some embodiments.

As shown in FIG. 4A, in some embodiments, a substrate 250 is provided, a plurality of electrodes 215 are disposed over the substrate 250, and a plurality of protrusions 251 are formed. Each of the protrusions 251 may be filled into a gap between adjacent electrodes 215. Next, in some embodiments, a carrier injection layer 261 is disposed over surfaces of the protrusions 251 and the electrodes 215, and a carrier transportation layer 262 is disposed over a surface of the carrier injection layer 261. Then, in some embodiments, a buffer layer 301 is disposed over the protrusions 251, and the buffer layer 301 also covers the carrier injection layer 261, the carrier transport layer 262, and one electrode 215. The buffer layer 301 is used to block moisture from passing through or entering the protrusions 251, the carrier injection layer 261, and the carrier transport layer 262.

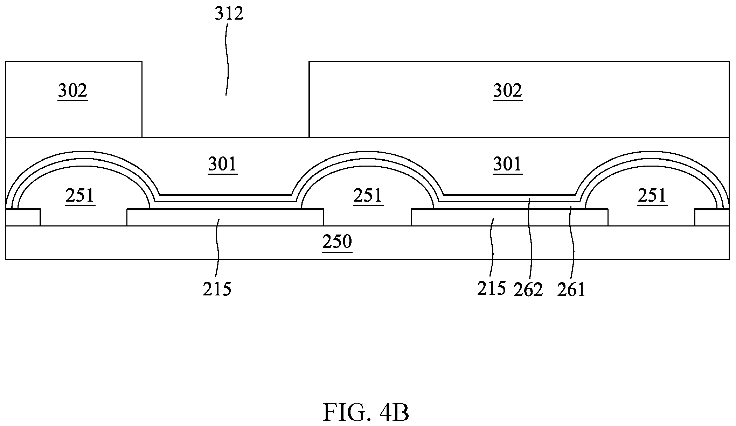

As shown in FIG. 4B, in some embodiments, a photosensitive layer 302 is disposed over the buffer layer 301. The photosensitive layer 302 may be further patterned by means of a lithography process, such that a portion of the buffer layer 301 is exposed through a groove 312.

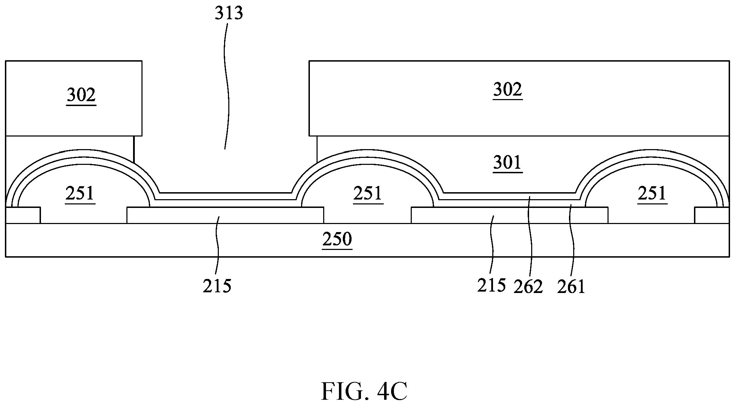

As shown in FIG. 4C, in some embodiments, the portion of the buffer layer 301 is removed to form a groove 313, so as to expose the carrier transportation layer 262. In some embodiments, the buffer layer 301 is removed by means of a wet etching process. In some embodiments, an etching agent may include fluorine-containing ions and/or a compound containing fluorine-containing ions.

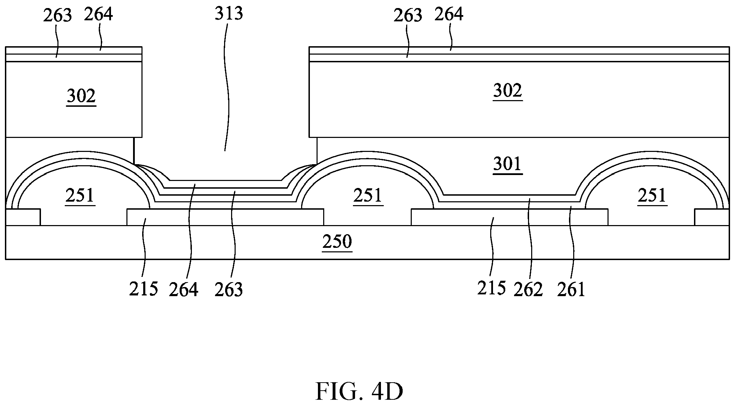

As shown in FIG. 4D, in some embodiments, a carrier transportation layer 263 is disposed over the carrier transport layer 262, and then an organic emissive layer 264 is disposed over the carrier transportation layer 263.

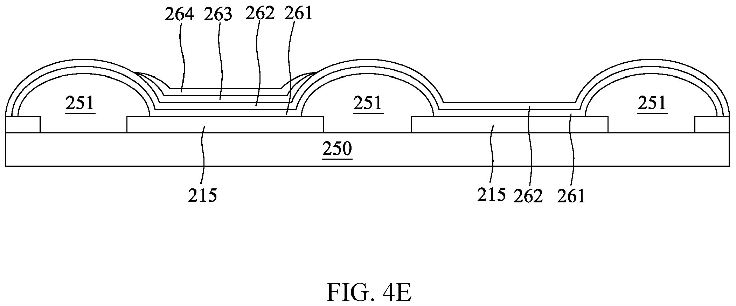

As shown in FIG. 4E, in some embodiments, the buffer layer 301, the photosensitive layer 302, and portions of the carrier transportation layer 263 and the organic emissive layer 264 over the photosensitive layer 302 are removed. In some embodiments, the buffer layer 301, the photosensitive layer 302, and a portion of the carrier transportation layer 263 and a portion of the organic emissive layer 264 are removed by means of a wet etching process. In some embodiments, an etching agent may include fluorine-containing ions and/or a compound containing fluorine-containing ions.

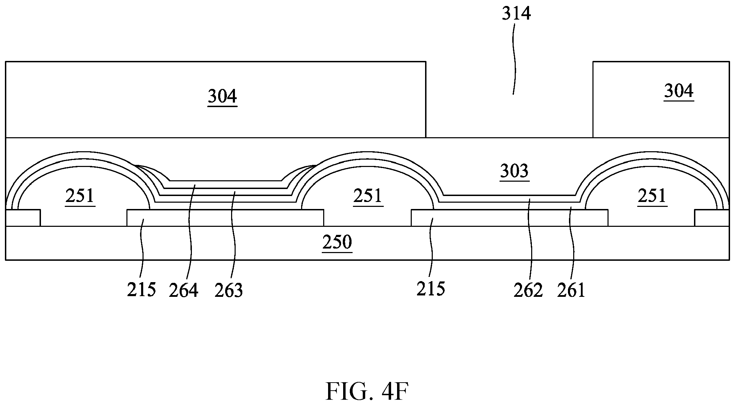

As shown in FIG. 4F, in some embodiments, a buffer layer 303 is disposed over the protrusions 251, and the buffer layer 303 also covers the carrier injection layer 261, the carrier transportation layer 262 and another electrode 215. Next, in some embodiments, a photosensitive layer 304 is disposed over the buffer layer 303. The photosensitive layer 304 may be further patterned by means of a lithography process, such that a portion of the buffer layer 303 is exposed through a groove 314.

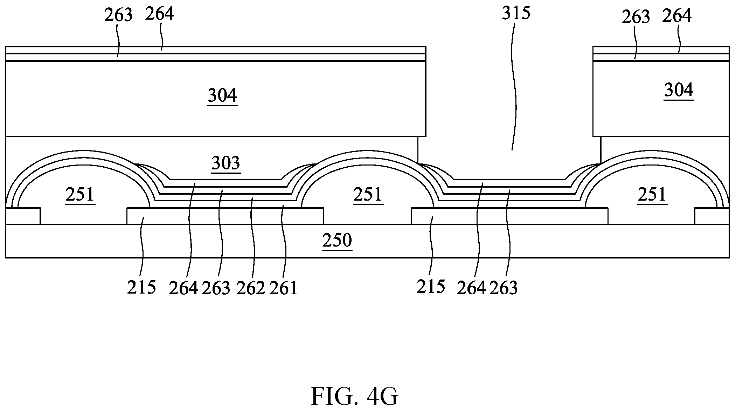

As shown in FIG. 4G, in some embodiments, the portion of the buffer layer 303 is removed to form a groove 315, so as to expose the carrier transportation layer 262. In some embodiments, the buffer layer 303 is removed by means of a wet etching process. In some embodiments, an etching agent may include fluorine-containing ions and/or a compound containing fluorine-containing ions. Next, in some embodiments, a carrier transportation layer 263 is disposed over the carrier transportation layer 262, and an organic emissive layer 264 is disposed over the carrier transportation layer 263.

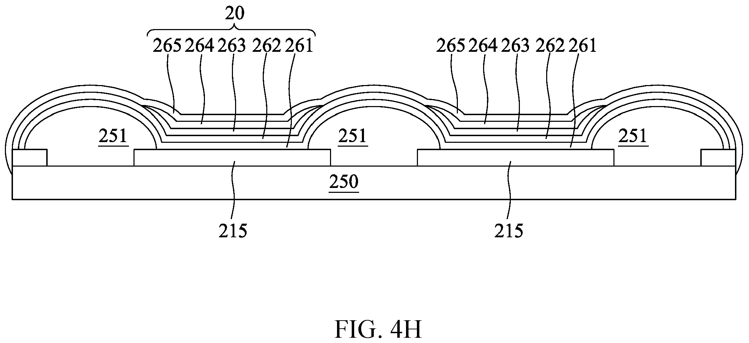

As shown in FIG. 4H, in some embodiments, the buffer layer 303, the photosensitive layer 304, and a portion of the carrier transportation layer 263 and a portion of the organic emissive layer 264 over the photosensitive layer 304 are removed. In some embodiments, the buffer layer 303, the photosensitive layer 304, and a portion of the carrier transportation layer 263 and a portion of the organic emissive layer 264 are removed by means of a wet etching process. In some embodiments, an etching agent may include fluorine-containing ions and/or a compound containing fluorine-containing ions. Next, in some embodiments, an organic carrier transportation layer 265 is disposed over the organic emissive layer 264.

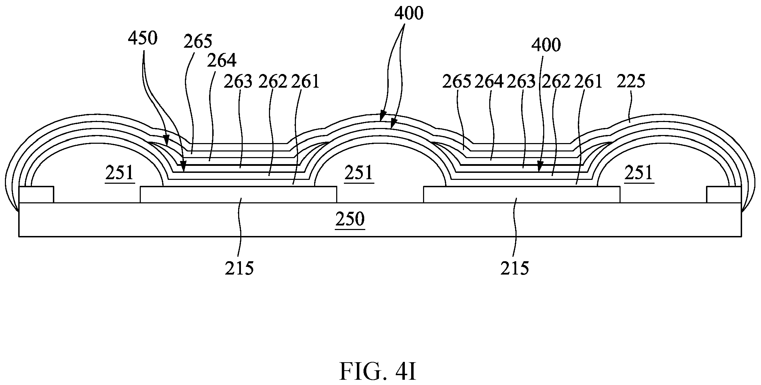

As shown in FIG. 4I, in some embodiments, electrodes 225 are disposed over the organic carrier transportation layer 265. As such, the structure shown in FIG. 3 has been manufactured.

The features of some embodiments are given in brief in the description above for a person skilled in the art to better understand various aspects of the present disclosure. A person skilled in the art would be able to understand that the present disclosure can be used as the basis for designing or modifying other manufacturing processes and structures so as to achieve the same objects and/or the same advantages of the embodiments described in the present application. A person skilled in the art would also be able to understand that such structures do not depart from the spirit and scope of the disclosure of the present application, and various changes, substitutions and replacements may be made by a person skilled in the art without departing from the spirit and scope of the present disclosure.

## Claims

1. An organic light emitting element, comprising:
a substrate;
a first electrode over the substrate;
an organic light emitting layer over the first electrode; and
a fluorine-containing ion residue region on at least one surface of the organic light emitting layer.

2. The organic light emitting element according to claim 1, wherein the fluorine-containing ion residue region comprises -C-F ions, a compound containing C-F ions, fluoride ions, a compound containing fluoride ions, a residue thereof, or any combination thereof.

3. The organic light emitting element according to claim 1, wherein the fluorine-containing ion residue region is further located between the organic light emitting layer and the first electrode.

4. The organic light emitting element according to claim 1, further comprising a protrusion structure over the substrate and partially covering the first electrode, wherein the fluorine-containing ion residue region is further located over the protrusion structure.

5. The organic light emitting element according to claim 4, wherein the fluorine-containing ion residue region is further located between the organic light emitting layer and the protrusion structure.

6. The organic light emitting element according to claim 4, further comprising a second electrode over the organic light emitting layer, wherein the fluorine-containing ion residue region is further located between the organic light emitting layer and the second electrode.

7. The organic light emitting element according to claim 6, wherein the second electrode is further disposed over the protrusion structure, and the fluorine-containing ion residue region is further located between the protrusion structure and the second electrode.

8. The organic light emitting element according to claim 4, wherein a fluorine-containing ion concentration of the fluorine-containing ion residue region over the protrusion structure is higher than a fluorine-containing ion concentration of the fluorine-containing ion residue region over the organic light emitting layer.

9. The organic light emitting element according to claim 1, wherein the organic light emitting layer further comprises a plurality of material layers, and the fluorine-containing ion residue region is further located among the plurality of material layers.

10. The organic light emitting element according to claim 1, wherein at least one of the substrate, the first electrode, and the organic light emitting layer is substantially free of fluorine.
